# EUROPÄISCHE PATENTSCHRIFT

(11) **EP 2 927 304 B1**
(45) Veröffentlichungstag und Bekanntmachung des Hinweises auf die Patenterteilung: **08.08.2018**
(21) Anmeldenummer: 15000950.4
(22) Anmeldetag: 01.04.2015
(51) Int. Cl.: F23C 99/00, C10G 32/02, H03B 1/00, H03B 5/08

(54) **VORRICHTUNG ZUR ELEKTROMAGNETISCHEN BEHANDLUNG VON BRENNSTOFFEN**
DEVICE FOR ELECTROMAGNETIC TREATMENT OF FUELS
DISPOSITIF DE TRAITEMENT ÉLECTROMAGNÉTIQUE DE COMBUSTIBLES

(30) Priorität: 03.04.2014 CH 527142014
(43) Veröffentlichungstag der Anmeldung: 07.10.2015
(73) Patentinhaber: Foculescu, Grigore, 012136 Bukarest (RO)
(72) Erfinder: Naiu, Mircea, 91056 Erlangen (DE); Foculescu, Grigore, 012136 Bukarest (RO); Mihalache, Florin, 023841 Bukarest (RO)
(74) Vertreter: Naiu, Radu Mircea

(56) Entgegenhaltungen:
- DE-A1- 3 133 482
- DE-A1-102005 017 768

## Beschreibung

### Technisches Gebiet

Die Erfindung betrifft eine Vorrichtung zur elektromagnetischen Behandlung von festen oder flüssigen oder gasförmigen Brennstoffen mittels eines elektrischen Feldes und ein Verfahren zum Betrieb der Vorrichtung gemäss den unabhängigen Ansprüchen.

### Hintergrund

Energieeinsparung ist ein immer wichtigeres Thema im Hinblick auf den immer grösseren Energiebedarf der Erdbevölkerung und im Hinblick auf die Schonung der Umwelt. Die Energieeinsparung beinhaltet, ausser einen verantwortungsvollen Umgang mit energieverbrauchenden Geräten und Anlagen, auch Massnahmen für die Geräte selbst. Beispielsweise wird Energie durch Selbstabschaltung von Geräten bei längerer Nichtnutzung eingespart. In anderen Fällen, wie z.B. bei Heizungssystemen, wird Energie auch durch eine entsprechend wirkungsvolle Wärmedämmung der zu heizenden Räume eingespart. Im Falle von Geräten die mit Brennstoffen betrieben werden, wird Energie u.a. durch Computer-gesteuerte Abgabe des Brennstoffs, wie z.B. Einspritzsysteme, usw. eingespart. Eine Vorrichtung zur Erzeugung eines elektrischen Feldes zur Behandlung von Brennstoff ist bekannt aus der DE 3133482. Die DE 102005017768 beschreibt eine Vorrichtung zur Aktivierung von Brennstoffen mittels eines Magnetfeldes.

### Darstellung der Erfindung

Die Aufgabe der vorliegenden Erfindung ist die Verbesserung der Energiebilanz bei Systemen und Anlagen, die mit festen, flüssigen oder gasförmigen Brennstoffen betrieben werden.

Diese Aufgabe wird mit.einer Vorrichtung gemäss Anspruch 1 gelöst.

Es wird eine Vorrichtung zur elektromagnetischen Behandlung von festen oder flüssigen oder gasförmigen Brennstoffen mittels eines elektromagnetischen Wechselfeldes welches auf Brennstoffmoleküle einwirkt, bereitgestellt. Die erfindungsgemässe Vorrichtung umfasst mindestens ein Resonanzoszillatormodul zur Erzeugung eines elektrischen Wechselfeldes, das auf Brennstoffmoleküle des Brennstoffes zur Erhöhung einer kalorischen Energie des Brennstoffs einwirkt, und ein Versorgungsmodul zur Speisung des mindestens einen Resonanzoszillatormoduls mit einer Wechselspannung. Das Resonanzoszillatormodul umfasst mehrere untereinander verbundene Schwingkreise, wobei die Gesamtheit der Schwingkreise mehrere Spulen und mehrere Kondensatoren umfassen. Jede Spule ist aus genau einer geschlossenen Windung gebildet und jeder Kondensator ist mit zwei Spulen verbunden, derart, dass Verbindungspunkte der Kondensatoren entlang der geschlossenen Windung verteilt und voneinander beabstandet sind. Jede Spule ist derart mit mindestens einer anderen Spule verbunden, dass die verbundenen Spulen keine gemeinsame Kondensatorverbindung haben.

Ein nicht erfindungsgemässes Verfahren zum Betrieb der erfindungsgemässen Vorrichtung umfasst die Schritte:
- Ermitteln der Anzahl von zu verwendenden Resonanzoszillatormodulen in Abhängigkeit von einer Menge des zu behandelnden Brennstoffs und Anschliessen der Resonanzoszillatormodule,
- Wählen eines Frequenzspektrums für eine erste und/oder eine zweite und/oder eine dritte Frequenz der Wechselspannung, wobei die erste, zweite und dritte Frequenz jeweils eine Frequenzkomponente des Frequenzspektrums ist und zur Ansteuerung des Resonanzoszillatormoduls oder der Resonanzoszillatormodule mittels eines Frequenzmodulators der Vorrichtung dient, auf der Basis des Aggregatzustands des Brennstoffs,
- Einstellen der Vorrichtung zur Erzeugung dieser Frequenz; und
- Starten der Vorrichtung zur Generierung des elektrischen Wechselfelds.

Die erfindungsgemässe Vorrichtung kann für alle mit Brennstoffen betriebenen Anlagen verwendet werden, vorzugsweise für Kohlekraftwerke, Heizölbrenner, Gaskraftwerke, Verbrennungsmotoren, industrielle Öfen und Hochöfen.

Die Brennstoffe, deren kalorische Energie mittels der erfindungsgemässen Vorrichtung erhöht werden kann, umfassen Kohle, Heizöl, Methangas, Diesel, Benzin, Kerosin usw.

Es hat sich gezeigt dass durch die Erzeugung eines elektromagnetischen Wechselfeldes mit einem hochfrequenten Frequenzspektrum die Ruheenergie der Moleküle des dem Wechselfeld ausgesetzten Brennstoffs in der chemischen Zusammensetzung verändert wird. Mit anderen Worten ist es möglich, die chemischen Verbindungen zwischen Sauerstoff und den Brennstoffmolekülen zu erleichtern, da die Elektronenaffinität für andere Elektronen, insbesondere für Elektronen des Sauerstoffs steigt.

Aufgrund der Einwirkung des elektromagnetischen Wechselfeldes, das von der erfindungsgemässen Vorrichtung generiert wird, führen die Brennstoffmoleküle, auf die die Energie des Wechselfeldes mit Hilfe zirkulär polarisierter Wellen, die ihrerseits die Energieniveaus der Elektronen der Brennstoffmoleküle ändern, einwirkt, zu einer Änderung der Quantenzahlen die die Gesamtenergie der Atome des behandelten Brennstoffs definieren. Als Folge wird der Brennwert oder die kalorische Energie des Brennstoffs erhöht, was zu einer effizienteren Verwendung des Brennstoffs führt. Mit anderen Worten wird es dadurch möglich, weniger Brennstoff für dasselbe Resultat zu verwenden. Die durch die Vorrichtung geschaffene Optimierung des Brennwertes hat als Folge eine Brennstoffeinsparung im zweistelligen Prozentbereich.

### Kurze Beschreibung der Zeichnungen

Weitere bevorzugte Ausführungen der Erfindung ergeben sich aus den abhängigen Ansprüchen und aus der nun folgenden Beschreibung anhand der Figuren. Dabei zeigen:
Fig. 1 ein Blockdiagramm der erfindungsgemässen Vorrichtung,
Fig. 2 eine Draufsicht auf einer ersten Glastextolitplatte des Resonanzoszillatormoduls der erfindungsgemässen Vorrichtung;
Fig. 3 eine Draufsicht auf einer zweiten Glastextolitplatte des Resonanzoszillatormoduls;
Fig. 4 ein Schaltbild des Resonanzoszillatormoduls; und
Fig. 5 eine vereinfachte perspektivische Ansicht eines beispielhaften Resonanzoszillatormoduls in einer Implementierung.

### Wege zur Ausführung der Erfindung

Im Folgenden bezeichnen gleiche Bezugszeichen gleiche Elemente der Ausführungsformen der Erfindung in Bezug auf Struktur und/oder Funktion.

Es wird bemerkt, dass der Begriff "Sauerstoffatom" der Einfachheit halber im Zusammenhang des vorliegenden Dokuments als Oberbegriff für Sauerstoffverbindungen zu verstehen ist. Dabei sind Verbrennungsvorgänge mit reinem Sauerstoff (Atome), z.B. in chemischen Industrieanlagen, aber auch Verbrennungen mit Luft (Moleküle), z.B. Heizölbrenner im Haushalt, mitumfasst.

Im Kontext dieses Dokuments ist der Begriff "im Wesentlichen elliptisch" oder "im Wesentlichen elliptische Form" so zu verstehen, dass die Form höchstens 40%, bezogen auf die Halbachse und/oder Nebenachse, von einer Ellipse abweichen kann.

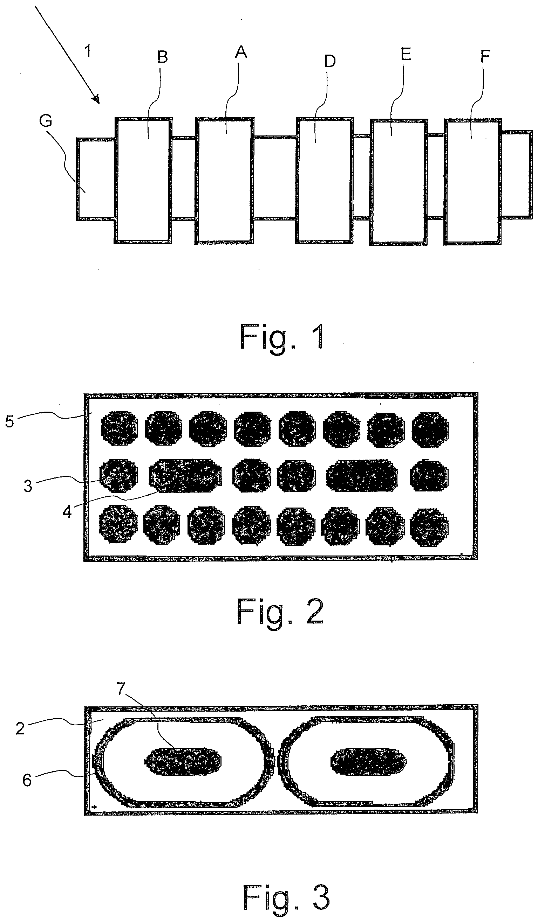

Fig. 1 zeigt ein Blockdiagramm der erfindungsgemässen Vorrichtung. Sie umfasst einen Frequenzmodulator A, ein Versorgungsmodul B und drei Resonanzoszillatormodule D, E, F.

Die Anzahl der Resonanzoszillatormodule ist hier beispielhaft gewählt. Grundsätzlich ist ein Betrieb mit mindestens einem Resonanzoszillatormodul D möglich. Die Anzahl der Resonanzoszillatormodule D-F richtet sich nach der Menge des zu behandelnden Brennstoffs. Je grösser die Menge des zu verbrennenden Brennstoffs pro Zeiteinheit ist, desto mehr Resonanzoszillatormodule D-F werden benötigt, um die nötige Energie für die molekulare Einwirkung auf die Brennstoffmoleküle und Sauerstoffatome bereitzustellen. Die Anzahl der Resonanzoszillatormodule D-F ist eine Treppenfunktion der Brennstoffmenge. Dies ist im Zusammenhang des vorliegenden Dokuments so zu verstehen, dass bei linearem Anstieg der Brennstoffmenge sich die Anzahl der Resonanzoszillatormodule ab einem vorgegebenen Wert um 1 erhöht. Der vorgegebene Wert hängt vom gewünschten Wirkungsgrad der Vorrichtung ab. Betrachtet man beispielsweise eine Brennstoffmenge bei der gerade noch ein akzeptabler Wirkungsgrad mit einem Resonanzoszillatormodul erreicht wird, so ist es vorteilhaft, ein zweites Resonanzoszillatormodul hinzuzufügen, um den Wirkungsgrad durch Zuführung von mehr Energie zu erhöhen.

Vorzugsweise umfasst die Vorrichtung 1 Verbindungsmittel G, die ein Hinzufügen oder Entnehmen von Resonanzoszillatormodulen erlauben. Die Verbindungsmittel G umfassen insbesondere einen Befestigungsrahmen 2, der beispielsweise ein U-Profil sein kann, und elektrische Kontakte (nicht gezeigt), vorzugsweise eingebettet im Befestigungsrahmen, für das elektrische Anschliessen der Resonanzoszillatormodule an das Versorgungsmodul B und den Frequenzmodulator A. Dadurch dass die elektrischen Verbindungen im Befestigungsrahmen eingebettet sind, wird das Risiko von Stromschlägen minimiert. Der Befestigungsrahmen ist aus einem Stahlblech oder einem anderen geeigneten Material hergestellt und ist im Hinblick auf Blechdicke und Form derart dimensioniert, dass er resistent gegen Durchbiegung im Hinblick auf das Gewicht der darauf passenden Module ist.

In einer bevorzugten Ausführungsform ist eine Erkennungselektronik vorgesehen, die die Anzahl der Resonanzoszillatormodule ermittelt und an eine Steuerung des Versorgungsmoduls übermittelt. Dadurch wird eine automatische Anpassung der zur Speisung aller Module nötigen Energie durch das Versorgungsmodul B erreicht. Dabei wird bei der Vorrichtung eine Wechselspannung zwischen 5000V und 8000V verwendet. Selbstverständlich wird vom Versorgungsmodul auch eine Stromstärke bereitgestellt, die ausreichend für den optimalen Betrieb der Resonanzoszillatormodule ist.

Vorzugsweise ist bzw. sind das mindestens eine Resonanzoszillatormodul und/oder das Versorgungsmodul und/oder der Frequenzmodulator in Epoxidharz gegossen. Dies hat den Vorteil dass die Vorrichtung bzw. ihre Module vor Staub und Feuchtigkeit geschützt sind. Dabei wird insbesondere ein Epoxidharz verwendet, das hohen Temperaturen und Durchschlagspannungen ausgesetzt werden kann.

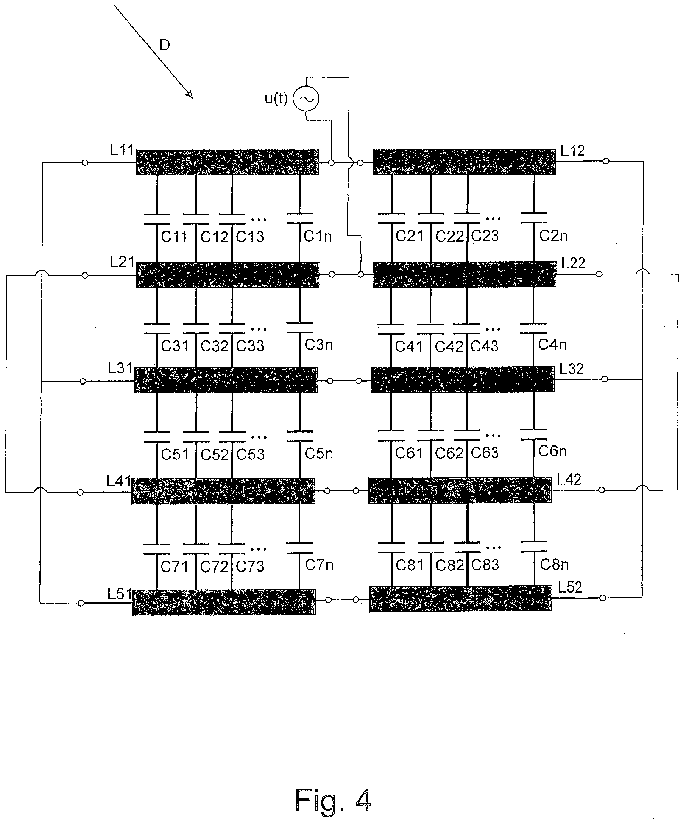

Wie oben erwähnt steuert der Frequenzmodulator A die Resonanzoszillatormodule D-F mit einer Frequenz, die aus einer ersten, einer zweiten und einer dritten Frequenz wählbar sind, je nachdem ob es sich beim zu behandelnden Brennstoff um einen festen, flüssigen oder gasförmigen Brennstoff handelt. Die erste Frequenz ist eine Frequenzkomponente eines Frequenzspektrums von 25 bis 100 GHz, die zweite Frequenz eine Frequenzkomponente eines Frequenzspektrums von 15 bis 25 GHz und die dritte Frequenz eine Frequenzkomponente eines Frequenzspektrums von 1 bis 90 GHz sind. Es wird ausdrücklich darauf hingewiesen, dass die Vorrichtung auch ohne Frequenzmodulator A funktioniert, wenn eine geeignete Wellenform der Eingangsspannung u(t) (Fig. 4) bereitgestellt wird.

Vorzugsweise umfasst das Resonanzoszillatormodul mindestens zwei Glastextolitplatten, die jeweils einer ersten und einer zweiten Gruppe angehören.

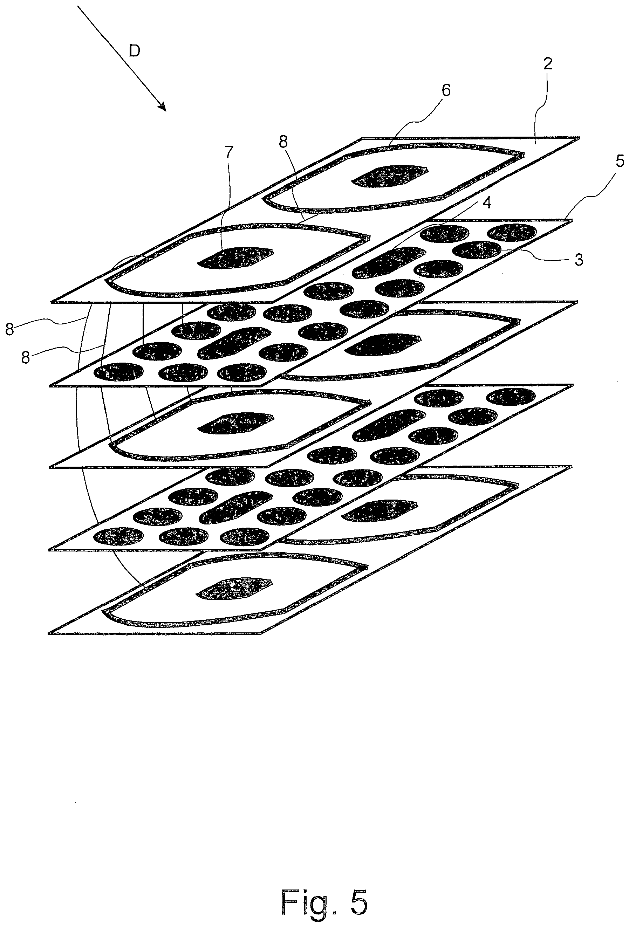

Fig. 2 zeigt eine Draufsicht auf einer ersten Glastextolitplatte 2 der Resonanzoszillatormodule D-F. Die Glastextolitplatte 2 ist mindestens auf einem Bereich der Oberfläche einseitig oder beidseitig mit einer Schicht Elektrolytkupfer (99,99%) beschichtet. Der beschichtete Bereich kann mindestens eine oktogonale Fläche 3 und mindestens eine längliche oktogonale Fläche 4 umfassen, wobei im vorliegenden Beispiel zwanzig oktogonale Flächen 3 und zwei längliche oktogonale Flächen 4 vorgesehen sind. Die länglichen oktogonalen Flächen 4 sind von den oktogonalen Flächen 3 umgeben. Andere Formen, z.B. runde Flächen 3 (vgl. Fig. 5), können auch zum Einsatz kommen.

Fig. 3 zeigt eine Draufsicht auf einer zweiten Glastextolitplatte 5 der Resonanzoszillatormodule D-F. Die zweite Glastextolitplatte 5 ist ebenfalls mindestens auf einem Bereich der Oberfläche einseitig oder beidseitig mit einer Schicht Elektrolytkupfer (99.99%) beschichtet. Der beschichtete Bereich ist durch zwei ringförmige Flächen 6 gebildet. Wie aus Fig. 3 ersichtlich haben die ringförmigen Flächen eine im Wesentlichen elliptische Form, wobei die obere und untere Extremität abgeplättet sind. Im Inneren jeder ringförmigen Fläche 6 ist ein metallisiertes Loch 7 zum Verbinden der ringförmigen Flächen 6 vorgesehen.

Die beschichteten oktogonalen Flächen 3 und 4 der ersten Glastextolitplatte 2 sind mit den beschichteten ringförmigen Flächen 6 der zweiten Glastextolitplatte 5 mittels einer Vielzahl von Leitern elektrisch verbunden, was im Zusammenhang mit Fig. 5 näher beschrieben wird.

Fig. 4 zeigt ein Schaltbild des Resonanzoszillatormoduls und Fig. 5 eine vereinfachte perspektivische Ansicht eines beispielhaften Resonanzoszillatormoduls in einer Implementierung. Im Folgenden werden aus Vereinfachungsgründen die beiden Figuren in einer Zusammenschau beschrieben. Wie insbesondere aus dem Aufbau von Fig. 5 ersichtlich ist, handelt es sich dabei um eine "drei-dimensionale" Verschaltung, da nicht nur einige Bauteile (Spulen) einzelner Ebenen (Leiterplatten) elektrisch verbunden sind, sondern auch Bauteile benachbarter Ebenen und die Ebenen untereinander. Dabei ist das Resonanzoszillatormodul D, E, F Sandwich-förmig aufgebaut. Jeweils zwischen zwei Leiterplatten 2 der ersten Gruppe ist eine Leiterplatte 5 der zweiten Gruppe angeordnet. Vorzugsweise sind fünf Leiterplatten 2 der ersten Gruppe und 4 Leiterplatten 5 der zweiten Gruppe vorgesehen, wobei in Fig. 5 der Einfachheit halber nur insgesamt 5 Leiterplatten gezeigt sind.

In der Zusammenschau der Figuren entsprechen die Spulen L11 und L12 (Fig. 4) den Spulen 6 der obersten Leiterplatte 2 aus Fig. 5 und die Kondensatoren C11-C1n bzw. C21-C2n (Fig. 4) entsprechen den Kondensatoren 3 der zweiten Ebene (Fig. 5) usw. Wiederum sind die Spulen L11, L31, L51 bzw. L21 und L41 miteinander verbunden. Entsprechend sind die Spulen L12, L32, L52 bzw. die Spulen L22 und L42 miteinander verbunden. Ausserdem sind die Spulen jeder Leiterplatte (z.B. L11 und L12) miteinander verbunden.

Die Eingangsspannung u(t) wird zwischen der Verbindung der Spulen einer der Leiterplatten und der Verbindung der Spulen einer zweiten Leiterplatte angelegt. Wie oben erwähnt kann die Eingangsspannung u(t) (5000-8000V) entweder direkt vom Versorgungsmodul B oder vom Frequenzmodulator A geliefert werden und wird zwischen zwei der Leiterplatten der ersten Gruppe angelegt, wie in Fig. 4 ersichtlich.

Die Verbindungen 8 zwischen den Leiterplatten sind in Fig. 5 nur schematisch und unvollständig dargestellt, um die Übersichtlichkeit der Figur zu bewahren. Die mit Elektrolytkupfer beschichteten Bereiche sind durch die dicken Linien bzw. schwarzen Flächen dargestellt. Die Leiterplatten 2 der ersten Gruppe sind auf einer Seite beschichtet. Der beschichtete Bereich der Leiterplatten 2 kann mindestens eine Spule umfassen, wobei hier zwei Spulen vorgesehen sind. Die geschlossene Windung ist von einer ringförmigen Fläche 6 gebildet. Die Leiterplatten 5 mit Kondensatoren sind beidseitig beschichtet. Die in Fig. 5 sichtbaren beschichteten Bereiche 3 der Leiterplatten 5 sind entsprechenden beschichteten Bereichen auf der anderen Seite der Leiterplatten 5 zugeordnet (nicht sichtbar), derart, dass jeweils zwei einander zugeordnete beschichtete Bereiche einen der Kondensatoren 3 bilden. Vorzugsweise haben die einander zugeordneten beschichteten Bereiche entweder eine erste Form oder eine zweite Form. Insbesondere umgeben die Kondensatoren 3 der ersten Form die Kondensatoren 4 der zweiten Form. Die erste Form kann oktogonal, hexagonal oder kreisrund sein. Die zweite Form kann eine elliptische Fläche 4 sein, die im Bereich der Nebenscheitel abgeplättet ist. Selbstverständlich können die Kondensatoren und Spulen aber auch andere Formen haben.

Vorzugsweise sind zwanzig Kondensatoren der ersten Form und zwei Kondensatoren der zweiten Form pro Leiterplatte vorgesehen. Jeder Kondensator 3 ist jeweils mit einer Spule der zwei benachbarten Leiterplatten 2 der ersten Gruppe elektrisch verbunden.

Im Folgenden wird der Betrieb bzw. die Inbetriebnahme der Vorrichtung 1 beschrieben. Dabei ist zu bemerken dass das Resonanzoszillatormodul D, E, F vorzugsweise derart ausgestaltet ist, dass das von ihm erzeugte elektromagnetische Wechselfeld zirkulär polarisiert ist. Auch kann in einer Ausführungsform das Resonanzoszillatormodul derart vom Versorgungsmodul gespeist werden, dass das vom Resonanzoszillatormodul erzeugte elektromagnetische Wechselfeld eine Energie aufweist, die Brennstoffmoleküle oder Brennstoffatome bzw. -Elektronen anregt.

Zunächst wird die Anzahl von zu verwendenden Resonanzoszillatormodulen D, E, F ermittelt. Wie oben erwähnt hängt dieser Schritt von der zu generierenden Leistung ab, die ihrerseits von der Brennstoffmenge abhängt. Anschliessend werden die ermittelten Resonanzoszillatormodule D, E, F in die Vorrichtung eingebaut bzw. angeschlossen. Sie können als Steckmodule ausgeführt sein, so dass sie leicht in den dafür vorgesehenen Rahmen mit Kontakten eingesteckt bzw. daraus ausgesteckt werden können. Anschliessend wird ein Frequenzspektrum für die erste und/oder die zweite und/oder die dritte Frequenz der Wechselspannung aus dem Aggregatzustand des Brennstoffs gewählt, wobei die erste, zweite und dritte Frequenz jeweils eine Frequenzkomponente des Frequenzspektrums sind.

Es wird bemerkt dass die erfindungsgemässe Vorrichtung einerseits direkt zur Behandlung des Brennstoffs verwendet werden kann, jedoch kann sie bei geeigneter Platzierung auch auf dem sich in der Oxidationsphase (Verbrennung) befindlichen Brennstoff einwirken. Mit anderen Worten kann die Vorrichtung auch auf eine Flamme einwirken und die Verbrennung selbst begünstigen. Der Begriff "geeignete Platzierung" ist so zu verstehen, dass der optimale Abstand der Vorrichtung von der Flamme gefunden wird. Dies hängt von der örtlichen Gegebenheiten der Anlage, in der die erfindungsgemässe Vorrichtung verwendet wird, ab und ist normalerweise am leichtesten durch Experimentieren ermittelbar.

Beispielsweise kann das vom Resonanzoszillatormodul erzeugte elektromagnetische Feld derart beschaffen sein, dass eine Trägerfrequenz von 50 Hz mit dem hochfrequenten Frequenzspektrum, mit anderen Worten mit der variierenden ersten und/oder zweiten und/oder dritten Frequenz, moduliert wird. Dies ist besonders vorteilhaft wenn sich der Brennstoff und/oder die Verbrennung (Flamme) in einem im Wesentlichen geschlossenen Metallbehälter befinden, so dass aufgrund der 50 Hz Trägerfrequenz eventuellen Effekten eines Faraday-Käfigs entgegengewirkt wird. Dabei wird bevorzugt, die Vorrichtung gemäss der Erfindung im Bereich des Einlasses des Brennstoffs zu platzieren, um eine minimale Dämpfung der aufmodulierten Frequenzen zu erreichen.

Im Folgenden sind zwei Tabellen angegeben, die experimentelle Werte darstellen, welche die Wirkung der erfindungsgemässen Vorrichtung zur elektromagnetischen Behandlung von Brennstoffen aufzeigen. In Tabelle 1 sind gemessene Werte ohne eine erfindungsgemässe Vorrichtung dargestellt, während in Tabelle 2 gemessene Werte mit einer erfindungsgemässen Vorrichtung aufgezeigt sind.

Die Versuche basieren auf das Erhitzen von Wasser in einem Behälter mittels einer Ölheizung, wobei geeignete Temperatur, Durchflusssensoren, usw. zur Datenaquisition verwendet wurden. Die Regelung und Datenerfassung wurde mit dem SCADA-System der Siemens AG durchgeführt. Dabei sind die Eingangsgrössen, wie Wassertemperatur beim Eingang und Durchfluss möglichst ähnlich gehalten worden. Abweichungen ergeben sich selbstverständlich wegen des hohen Durchflusses. Die Messreihe wurde um 19:00 Uhr bzw. um 18:30 gestartet und Messwerte wurden jede halbe Stunde aufgezeichnet. Die letzte Spalte stellt die Wassermenge in Kubikmeter dar, die auf eine Gigakalorie entfällt. Bei einem Vergleich der Tabellen ist ersichtlich, dass ohne die erfindungsgemässe Vorrichtung ein Mittelwert von 131.46 m³ Wasser pro Gigakalorie entfallen, während mit der erfindungsgemässen Vorrichtung ein Mittelwert von 107.26 m³ Wasser pro Gigakalorie entfallen. Folglich konnte das Wasser effizienter mit der Vorrichtung erhitzt werden, als ohne.

**Tabelle 1**

| Zeit | Wassertemp. Eingang Behälter | Wassertemp. Ausgang Behälter | ΔT | Durchfluss Wasser in Tonnen | Gcal Stunde | m³/ Gcal |
|---|---|---|---|---|---|---|
| 19.00 | 78 | 100 | 22 | 2000 | 44.00 | 136.36 |
| | 77 | 95 | 19 | 2000 | 38.00 | 131.58 |
| | 76 | 92 | 16 | 2400 | 38.40 | 130.21 |
| | 76 | 92 | 16 | 2400 | 38.40 | 130.21 |
| | 74 | 90 | 16 | 2400 | 38.40 | 130.21 |
| | 74 | 90 | 16 | 2400 | 38.40 | 130.21 |
| **Mittel** | **75.83** | **93.16** | **17.5** | **2266.66** | **39.26** | **131.46** |

**Tabelle 2**

| Zeit | Wassertemp. Eingang Behälter | Wassertemp. Ausgang Behälter | ΔT | Durchfluss Wasser in Tonnen | Gcal Stunde | m³/ Gcal |
|---|---|---|---|---|---|---|
| 18.30 | 79.00 | 99.00 | 20 | 1900 | 38.00 | 106.58 |
| | 78.00 | 98.00 | 20 | 1899 | 38.00 | 106.58 |
| | 77.00 | 96.00 | 19 | 2000 | 38.00 | 106.58 |
| | 77.00 | 95.00 | 18 | 2050 | 36.90 | 109.76 |
| | 76.00 | 93.00 | 17 | 2230 | 37.91 | 106.83 |
| **Mittel** | **77.6** | **96.2** | **16.8** | **2015.8** | **37.76** | **107.26** |

Obwohl vorteilhafte Ausführungsformen der Erfindung gezeigt und beschrieben wurden, ist die Erfindung nicht auf diese beschränkt, sondern sie kann im Rahmen des Geltungsbereiches der folgenden Ansprüche auf andere Weise ausgeführt und angewendet werden. Begriffe wie "vorzugsweise", "bevorzugt", "insbesondere", "vorteilhaft" usw. beziehen sich nur auf optionale und beispielhafte Ausführungsformen.

## Patentansprüche

1. Vorrichtung (1) zur elektromagnetischen Behandlung von Brennstoffen mittels eines elektromagnetischen Wechselfeldes welches auf Brennstoffmoleküle einwirkt, umfassend:
- mindestens ein Resonanzoszillatormodul (D, E, F) zur Erzeugung eines elektromagnetischen Wechselfeldes das auf Brennstoffmoleküle des Brennstoffes zur Erhöhung einer kalorischen Energie des Brennstoffs einwirkt,
- ein Versorgungsmodul (B) zur Speisung des mindestens einen Resonanzoszillatormoduls (D, E, F) mit einer Wechselspannung,
**dadurch gekennzeichnet, dass** das Resonanzoszillatormodul (D, E, F) mehrere untereinander verbundene Schwingkreise umfasst, wobei die Gesamtheit der Schwingkreise mehrere Spulen (6) und mehrere Kondensatoren (3, 4) umfassen, wobei jede Spule (6) aus genau einer geschlossenen Windung gebildet und jeder Kondensator (3, 4) mit zwei Spulen (6) verbunden ist, derart, dass Verbindungspunkte der Kondensatoren(3, 4) entlang der geschlossenen Windung verteilt und voneinander beabstandet sind, wobei jede Spule (6) derart mit mindestens einer anderen Spule (6) verbunden ist, dass die verbundenen Spulen (6) keine gemeinsame Kondensatorverbindung haben.

2. Vorrichtung nach Anspruch 1, wobei das Versorgungsmodul (B) derart strukturiert und ausgestaltet ist, dass die von ihm erzeugte Wechselspannung eine erste und/oder eine zweite und/oder eine dritte Frequenz aufweist.

3. Vorrichtung nach Anspruch 1, wobei ein Frequenzmodulator (A) vorgesehen ist, der zwischen dem Versorgungsmodul (B) und dem mindestens einen Resonanzoszillatormodul (D, E, F) geschaltet und derart strukturiert und ausgestaltet ist, dass er die vom Versorgungsmodul (B) erzeugte Wechselspannung mit einer ersten und/oder einer zweiten und/oder einer dritten Frequenz moduliert.

4. Vorrichtung nach Anspruch 2 oder 3, wobei das Versorgungsmodul (B) derart ausgestaltet ist, dass die erste Frequenz der Wechselspannung eine Frequenzkomponente eines Frequenzspektrums von 25 bis 100 GHz, die zweite Frequenz der Wechselspannung eine Frequenzkomponente eines Frequenzspektrums von 15 bis 25 GHz und die dritte Frequenz der Wechselspannung eine Frequenzkomponente eines Frequenzspektrums von 1 bis 90 GHz sind.

5. Vorrichtung nach einem der vorangehenden Ansprüche, wobei das Resonanzoszillatormodul (D, E, F) mehrere Leiterplatten (2, 5), insbesondere Glastextolitplatten, umfasst, die mindestens auf einem Bereich ihrer Oberfläche mit einer Schicht elektrisch leitfähigen Materials, insbesondere Elektrolytkupfer, beschichtet sind, wobei die Leiterplatten (2, 5) einer ersten oder einer zweiten Gruppe von Leiterplatten zugeordnet sind, wobei die Leiterplatten (2) der ersten Gruppe einseitig oder beidseitig beschichtet sind und die Leiterplatten (5) der zweiten Gruppe beidseitig beschichtet sind.

6. Vorrichtung nach Anspruch 5, wobei der beschichtete Bereich der Leiterplatten (2) der ersten Gruppe mindestens eine Spule (6), insbesondere zwei Spulen (6), bildet, insbesondere wobei die geschlossene Windung von einer ringförmigen Fläche, insbesondere mit einer im Wesentlichen elliptischen Form, gebildet ist.

7. Vorrichtung nach Anspruch 5 oder 6, wobei beschichtete Bereiche auf einer Seite der Leiterplatten (5) der zweiten Gruppe entsprechenden beschichteten Bereichen auf der anderen Seite der Leiterplatten (5) der zweiten Gruppe zugeordnet sind, derart, dass jeweils zwei einander zugeordnete beschichtete Bereiche einen der Kondensatoren (3, 4) bilden.

8. Vorrichtung nach Anspruch 6 und 7, wobei das Resonanzoszillatormodul (D, E, F) Sandwich-förmig aufgebaut ist, wobei jeweils zwischen zwei Leiterplatten (2) der ersten Gruppe eine Leiterplatte (5) der zweiten Gruppe angeordnet ist, insbesondere wobei fünf Leiterplatten (2) der ersten Gruppe und 4 Leiterplatten (5) der zweiten Gruppe vorgesehen sind.

9. Vorrichtung nach Anspruch 8, wobei jeder Kondensator (3, 4) jeweils mit einer Spule (6) der zwei benachbarten Leiterplatten (2) der ersten Gruppe elektrisch verbunden ist.

10. Vorrichtung nach Anspruch 8 oder 9, wobei die Wechselspannung zwischen zwei der Leiterplatten (2) der ersten Gruppe angelegt ist.

11. Vorrichtung nach einem der Ansprüche 7 bis 10, wobei die einander zugeordneten beschichteten Bereiche entweder eine erste Form oder eine zweite Form haben, insbesondere wobei die Kondensatoren (3) der ersten Form die Kondensatoren (4) der zweiten Form umgeben und die erste Form eine oktogonale, hexagonale oder kreisrunde Fläche und die zweite Form eine im Wesentlichen elliptische Fläche sind, insbesondere wobei zwanzig Kondensatoren (3) der ersten Form und zwei Kondensatoren (4) der zweiten Form pro Leiterplatte (5) vorgesehen sind.

## Claims

1. Device (1) for electromagnetic treatment of fuels by means of an electromagnetic alternating field which acts upon fuel molecules, comprising:
- at least a resonance oscillator module (D, E, F) for generating an electromagnetic alternating field which acts upon fuel molecules of the fuel for increasing a caloric energy of the fuel,
- a supply module (B) for supplying an alternating voltage to the at least one resonance oscillator module (D, E, F),
**characterized in that** the resonance oscillator module (D, E, F) comprises a plurality of oscillating circuits mutually connected, wherein an entirety of the oscillating circuits comprise a plurality of coils (6) and a plurality of capacitors (3, 4), wherein each coil (6) is formed of precisely one closed winding and each capacitor (3, 4) is connected to two coils (6) in such a way that connection points of the capacitors (3, 4) are distributed along the closed winding and are spaced from one another, wherein each coil (6) is connected in such a way to at least a further coil (6) that the connected coils (6) have no common capacitor connection.

2. Device according to claim 1, wherein the supply module (B) is structured and formed in such a way that the alternating voltage generated by it has a first and/or a second and/or a third frequency.

3. Device according to claim 1, wherein a frequency modulator (A) is provided, being connected between the supply module (B) and the at least one resonance oscillator module (D, E, F) and being structured and formed in such a way that it modulates the alternating voltage generated by the supply module (B) with a first and/or a second and/or a third frequency.

4. Device according to claim 2 or 3, wherein the supply module (B) is adapted such that the first frequency of the alternating voltage is a frequency component of a frequency spectrum between 25 and 100 GHz, the second frequency a frequency component of a frequency spectrum between 15 and 25 GHz and the third frequency a frequency component of a frequency spectrum between 1 and 90 GHz.

5. Device according to one of the preceding claims, wherein the resonance oscillator module (D, E, F) comprises a plurality of circuit boards (2, 5), particularly glass textolite plates, which are coated on at least a section of their surface with a layer of an electrically conducting material, particularly electrolyte copper, wherein the circuit boards (2, 5) are attributed to a first or a second group of circuit boards, wherein the circuit boards (2) of the first group are coated on one side or on both sides and the circuit boards (5) of the second group are coated on both sides.

6. Device according to claim 5, wherein the coated section of the circuit boards (2) of the first group forms at least one coil (6), particularly two coils (6), particularly wherein the closed winding is formed by an annular surface, particularly having a substantially elliptic shape.

7. Device according to claim 5 or 6, wherein coated sections on one side of the circuit boards (5) of the second group are attributed to corresponding coated sections on the other side of the circuit boards (5) of the second group, in such a way that every two coated sections attributed to one another form one of the capacitors (3, 4).

8. Device according to claim 6 and 7, wherein the resonance oscillator module (D, E, F) is sandwich-shaped, wherein a circuit board (5) of the second group is arranged between two circuit boards (2) of the first group, particularly wherein five circuit boards (2) of the first group and four circuit boards (5) of the second group are provided.

9. Device according to claim 8, wherein each capacitor (3, 4) is electrically connected with a coil (6) of each one of the two neighbouring circuit boards (2) of the first group.

10. Device according to claim 8 or 9, wherein the alternating voltage is applied between two of the circuit boards (2) of the first group.

11. Device according to one of the claims 7 to 10, wherein the coated sections attributed to one another have either a first shape or a second shape, particularly wherein the capacitors (3) of the first shape surround the capacitors (4) of the second shape and the first shape is an octagonal, hexagonal or circular surface and the second shape is a substantially elliptic surface, particularly wherein twenty capacitors (3) of the first shape and two capacitors (4) of the second shape are provided on one circuit board (5).

## Revendications

1. Dispositif (1) pour le traitement électromagnétique de carburants à l'aide d'un champ électromagnétique alternatif qui agit sur les molécules du carburant, comprenant:
- au moins un module oscillateur résonateur (D, E, F) pour générer un champ électromagnétique alternatif qui agit sur des molécules de carburant du carburant afin d'augmenter une énergie calorique du carburant,
- un module d'alimentation (B) pour alimenter l'au moins un module oscillateur résonateur (D, E, F) avec une tension alternative,
- **caractérisé en ce que** le module oscillateur résonateur (D, E, F) comprend une pluralité de circuits oscillants connectés l'un avec l'autre, une totalité des circuits oscillants comprenant une pluralité de bobines (6) et une pluralité de capacités (3, 4), chaque bobine (6) étant formée de précisément une boucle fermée et chaque capacité (3, 4) étant connectée avec deux bobines (6) de sorte que les points de connexion des capacités (3, 4) sont distribués le long de la boucle fermée et sont espacés l'un par rapport à l'autre, chaque bobine (6) étant connectée avec au moins une autre bobine (6) de sorte que les bobines connectées (6) ont aucune connexion commune avec une capacité.

2. Dispositif selon la revendication 1, le module d'alimentation (B) étant structuré et formé de sorte que la tension alternative générée par lui-même a une première et/ou une deuxième et/ou une troisième fréquence.

3. Dispositif selon la revendication 1, un modulateur de fréquence (A) étant prévu, qui est connecté entre le module d'alimentation (B) et l'au moins un module oscillateur résonateur (D, E, F) et qui est structuré et formé de manière à moduler la tension alternative générée par le module d'alimentation (B) avec une première et/ou une deuxième et/ou une troisième fréquence.

4. Dispositif selon la revendication 2 ou 3, le module d'alimentation (B) étant adapté de sorte que la première fréquence de la tension alternative est une composante de fréquence d'un spectre de fréquences compris entre 25 et 100 GHz, la deuxième fréquence est une composante de fréquence d'un spectre de fréquences compris entre 15 et 25 GHz et la troisième fréquence est une composante de fréquence d'un spectre de fréquences compris entre 1 et 90 GHz.

5. Dispositif selon l'une des revendications précédentes, le module oscillateur résonateur (D, E, F) comprenant une pluralité de cartes de circuits (2, 5), particulièrement des plaques de verre de textolite, qui sont revêtues sur au moins une section de leur surface avec une couche d'un matériau qui conduit l'électricité, particulièrement du cuivre électrolytique, les cartes de circuits (2, 5) étant attribuées à un premier ou un deuxième groupe de cartes de circuits, les cartes de circuits (2) du premier groupe étant revêtues d'un côté ou de deux côtés et les cartes de circuits (5) du deuxième groupe étant revêtues des deux côtés.

6. Dispositif selon la revendication 5, la section revêtue des cartes de circuits (2) du premier groupe formant au moins une bobine (6), particulièrement deux bobines (6), particulièrement la boucle fermée étant formée par une surface annulaire, particulièrement ayant une forme essentiellement elliptique.

7. Dispositif selon la revendication 5 ou 6, des sections revêtues d'un côté des cartes de circuits (5) du deuxième groupe étant attribuées à des sections revêtues correspondantes de l'autre côté des cartes de circuits (5) du deuxième groupe, de sorte que chaque deux sections revêtues attribuées l'une à l'autre forment un des capacités (3, 4).

8. Dispositif selon les revendications 6 et 7, le module oscillateur résonateur (D, E, F) étant en forme de sandwich, une carte de circuits (5) du deuxième groupe étant arrangée entre deux cartes de circuits (2) du premier groupe, particulièrement cinq cartes de circuits (2) du premier groupe et quatre cartes de circuits (5) du deuxième groupe étant prévues.

9. Dispositif selon la revendication 8, chaque capacité (3, 4) étant connectée électriquement avec une bobine (6) de chacune des deux cartes de circuits (2) voisines du premier groupe.

10. Dispositif selon la revendication 8 ou 9, la tension alternative étant appliquée entre deux des cartes de circuits (2) du premier groupe.

11. Dispositif selon l'une des revendications 7 à 10, les sections revêtues attribuées l'une à l'autre ayant soit une première forme ou une deuxième forme, particulièrement les capacités (3) de la première forme entourant les capacités (4) de la deuxième forme et la première forme étant une surface octogonale, hexagonale ou circulaire et la deuxième forme étant une surface essentiellement elliptique, particulièrement vingt capacités (3) de la première forme et deux capacités (4) de la deuxième forme étant prévues sur une carte de circuits (5).
